# EUROPEAN PATENT APPLICATION

(11) **EP 2 799 509 A1**
(43) Date of publication of application: **05.11.2014**
(21) Application number: 12861419.5
(22) Date of filing: 21.12.2012
(51) Int. Cl.: C09J 163/00, C09J 11/04, C09J 7/00, C23C 26/00

(54) **INSULATING ADHESIVE COMPOSITION FOR METAL-BASED COPPER CLAD LAMINATE (MCCL), COATED METAL PLATE USING SAME, AND METHOD FOR MANUFACTURING SAME**

(30) Priority: 28.12.2011 KR 20110144908
(71) Applicant: Posco, Pohang-si, Gyeongsangbuk-do 790-300 (KR)
(72) Inventor: PARK, Chan Sup, Pohang-si Gyeongsangbuk-do 791-754 (KR); CHO, Rae-Hong, Pohang-si Gyeongsangbuk-do 790-758 (KR); KIM, Dong Hyon, Seoul 153-023 (KR); PARK, Kyung Ho, Seoul 153-023 (KR); HAN, Sang-Kwon, Pohang-si Gyeongsangbuk-do 790-350 (KR); PARK, Chong Soo, Seoul 153-023 (KR); LEE, Bae Geun, Pohang-si Gyeongsangbuk-do 790-705 (KR); KIM, Jung Bong, Pohang-si Gyeongsangbuk-do 790-705 (KR); HAN, Jae Man, Seoul 153-023 (KR); SHIN, Tae Kyoo, Seoul 153-023 (KR); BAE, Dae Chul, Seoul 150-042 (KR)
(74) Representative: Zech, Stefan Markus
(86) International application number: PCT/KR2012/011310
(87) International publication number: WO 2013/100502

(57) **Abstract**

The present invention relates to an insulating adhesive composition for metal printed circuit board, an adhesive-coated metal plate using the same, and a method for manufacturing the adhesive-coated metal plate. The adhesive composition according to the present invention forms an adhesive layer that is excellent in terms of adhesion to a copper foil, electrical insulating properties, and thermal resistance. The composition contains a specific epoxy resin, a curing agent and alumina. According to the present invention, in coating the metal plate with the solvent type adhesive, a roll coating method is used to perform a continuous coating process on the metal plate, thereby improving productivity when compared to the general method using a sheet type adhesive film.

## Description

### CROSS-REFERENCE TO RELATED APPLICATION

This application claims priority to and the benefit of Korean Patent Application No. 10-2011-0144908, filed December 28, 2011, the disclosure of which is incorporated herein by reference in its entirety.

### TECHNICAL FIELD

The present invention relates to an insulating adhesive composition for metal-based copper clad laminate (MCCL), an adhesive-coated metal plate using the same, and a method for manufacturing the coated metal plate.

### BACKGROUND ART

The printed circuit board is classified into resin-based printed circuit board and metal printed circuit board according to the type of the substrate. With a demand for high heat radiation (thermal conductivity) to the printed circuit boards, the recent trends are increasingly towards the metal printed circuit boards from the conventional resin-based printed circuit boards. The metal printed circuit boards are currently used for lighting and industrial purposes, such as, for example, LED substrates (e.g., substitutes for light bulbs, fluorescent bulbs, street lightings, advertisement lights, etc.), LED TVs, converters, inverters, power supply devices (SMPS), rectifiers, and so forth.

Generally, the metal printed circuit board consists of a metal plate, such as an aluminum plate, a magnesium plate, a melt aluminum-coated steel plate, a melt aluminum-zinc alloy-coated steel plate, a melt zinc-coated steel plate, an electrical zinc-coated steel plate, etc.; an insulating adhesive layer; and a copper foil layer. The functions required to the insulating adhesive layer are the adhesion to the metal plate and the copper foil layer, electrical insulating properties, and a function to maintain the initial adhesion and electrical insulating properties under heat and moisture (humidity) generated during the manufacturing process for the metal printed circuit boards.

On the other hand, there are two methods for the conventional process of forming an insulating adhesive layer. The one method is preparing an insulating adhesive layer as a dry film in the form of a sheet and the other is applying an adhesive to a copper foil to form an insulating adhesive layer. The former method involves laminating the insulating adhesive layer in the form of a sheet film and thus leads to deterioration in the working easiness and the productivity. The latter method is the most prevailing general manufacturing method.

### DISCLOSURE OF INVENTION

It is an object of the present invention to provide an insulating adhesive composition for metal printed circuit board excellent in terms of adhesion to a metal material and a copper foil and electrical insulating properties.

It is another object of the present invention to provide an adhesive-coated metal plate using the adhesive composition.

It is further another object of the present invention to provide a method for manufacturing an adhesive-coated metal plate that involves coating a metal material with a solution of the insulating adhesive composition in a high-temperature and high-speed continuous roll-coating line to enhance the productivity.

To achieve the objects of the present invention, there is provided an insulating adhesive composition for metal printed circuit board that includes a modified epoxy resin prepared by reacting a silicon compound represented by the following Chemical Formula 1 and an epoxy resin:

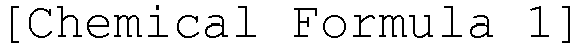

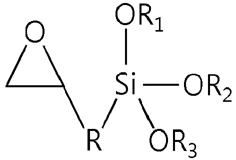

In the above chemical formula, R is an aliphatic or aromatic alkylene group; and R₁, R₂, and R₃ are independently an aliphatic or aromatic alkyl group.

In the present invention, the modified epoxy resin preferably includes 0.3 to 3 wt% of silicon (Si), and the modified epoxy resin preferably has an average epoxy equivalent weight of 170 to 1,000 g/eq.

The insulating adhesive composition according to the present invention may include an epoxy resin having a high equivalent weight, an inorganic filler, a curing agent, and an organic solvent.

In the present invention, the epoxy resin having a high equivalent weight may be at least one selected from the group consisting of a solid epoxy resin having an equivalent weight of 1,500 to 7,000 g/eq and a phenoxy resin having a weight average molecular weight of 20,000 to 70,000 g/mol.

In the present invention, the insulating adhesive composition other than the inorganic filler may have a weight average molecular weight of 2,000 to 60,000 g/mol.

In the present invention, the inorganic filler is preferably aluminum oxide, and the inorganic filler preferably has a particle size of 0.1 to 3.0 µm. The inorganic filler is preferably included in an amount of 40 to 70 wt% with respect to the total solid weight of the insulating adhesive composition.

In the present invention, the curing agent is any one or a mixture of at least two selected from the group consisting of a phenol novolac resin, an acid anhydride, an aromatic amine, an urea resin, a melamine resin, and a phenol resol derivative.

In the present invention, the phenol novolac resin has a softening temperature of 80 to 130°C.

In the present invention, the acid anhydride is preferably an acid anhydride represented by the following Chemical Formula 2:

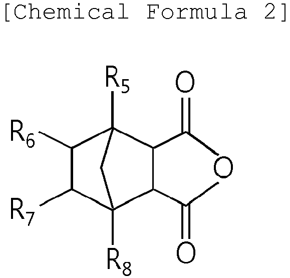

In the above chemical formula, R₅, R₆, R₇, and R₈ are independently hydrogen (H) or an aliphatic or aromatic alkyl group.

In the present invention, the aromatic amine is preferably an aromatic amine represented by the following Chemical Formula 3:

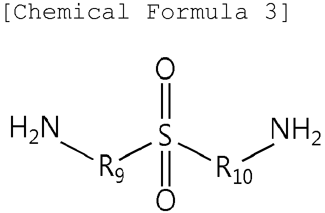

In the above chemical formula, R₉ and R₁₀ are independently an aromatic alkylene group.

In the present invention, the organic solvent preferably includes at least one solvent having a boiling temperature of 70 to 149°C and at least one solvent having a boiling temperature of 150 to 230°C.

The present invention also provides an adhesive-coated metal plate for metal printed circuit board that includes: a metal plate; and an insulating adhesive layer provided on the top of the metal plate and formed using an insulating adhesive composition containing a modified epoxy resin prepared by reacting a silicon compound represented by the Chemical Formula 1 and an epoxy resin.

In the present invention, the metal plate may be selected from the group consisting of an aluminum plate, a magnesium plate, a melt aluminum-coated steel plate, a melt aluminum-zinc alloy-coated steel plate, a melt zinc-coated steel plate, and an electrical zinc-coated steel plate.

In the present invention, the insulating adhesive layer preferably has a final coating thickness of 40 to 120 µm.

The present invention also provides a method for manufacturing an adhesive-coated metal plate for metal printed circuit board that includes: (a) continuously feeding a metal plate in a continuous roll-coating line; and (b) coating the top of the metal plate with an insulating adhesive composition containing a modified epoxy resin prepared by reacting a silicon compound represented by the Chemical Formula 1 and an epoxy resin and then drying the coated metal plate to form an insulating adhesive layer.

In the method for manufacturing an adhesive-coated metal plate for metal printed circuit board according to the present invention, the step (b) may include repeatedly performing the coating process using the insulating adhesive composition and drying process at least twice.

The method for manufacturing an adhesive-coated metal plate for metal printed circuit board according to the present invention may further includes the steps of adjusting the surface of the metal plate with a brush after the step (a), applying a protective film after the step (b), and installing a magnetic filter in the insulating adhesive composition to eliminate an iron oxide component before the step (b).

### EFFECTS OF THE INVENTION

The present invention provides an insulating adhesive composition for metal printed circuit board that uses an epoxy resin excellent in adhesion, thermal resistance and moisture resistance. Further, the insulating adhesive composition is a composition that can be easily prepared in a high-speed continuous roll-coating line and greatly enhances the productivity. In addition, the present invention is applicable to an aluminum plate, an aluminum-coated steel plate, a zinc-coated steel plate, an aluminum-zinc alloy-coated steel plate, an electrical zinc-coated steel plate, and so forth irrespective of the material of the plate, thereby securing various uses.

### BRIEF DESCRIPTION OF DRAWINGS

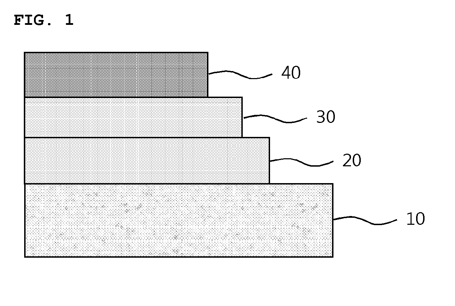

FIG. 1 is a cross-sectional diagram showing the structure of an adhesive-coated metal plate for metal printed circuit board manufactured according to one embodiment of the present invention.

### BEST MODES FOR CARRYING OUT THE INVENTION

Hereinafter, a detailed description will be given as to an insulating adhesive composition for a high-temperature and high-speed continuous roll-coating process and a coated metal plate using the same.

The composition of the insulating adhesive may consist of a main resin, a curing agent, a curing accelerator, an inorganic filler, a solvent, a dispersing agent, a coupling agent, a leveling agent, and/or a foaming agent, etc. and provided in the form of a one-component type composition.

The main resin of the adhesive composition consists of an epoxy resin. The epoxy resin available is not specifically limited and may preferably include an epoxy resin having at least two aromatic backbones and also at least two epoxy groups. Specific examples of the epoxy resin may include, but are not limited to, any epoxy resin commercially available, such as a bisphenol A type epoxy resin, a bisphenol F type epoxy resin, a biphenyl type epoxy resin, a tetramethyl biphenyl type epoxy resin, a novolac type epoxy resin, a rubber-modified epoxy resin, a thiobiphenyl type epoxy resin, a biphenyl sulfone type epoxy resin, a bisphenol A type phenoxy resin, a bisphenol F type phenoxy resin, a fluorene type phenoxy resin, etc., which may be used alone or in combination. Any one or at least two of the above-mentioned epoxy resins may be selected and used in the composition of the present invention, but the choice of the epoxy resin is possible totally depending on the physical and electrical characteristics of the desired adhesive.

In order to secure that the above-specified epoxy resin has a high adhesion between the metal material and the copper foil and easy processability in the continuous roll-coating process, the epoxy resin preferably includes at least one divalent epoxy resins having two epoxy groups. Examples of the divalent epoxy resin commercially available may include YD-128 (bisphenol A type liquid type standard epoxy resin), YD-134 (bisphenol A type semi-solid epoxy resin), YD-136 (bisphenol A type semi-solid epoxy resin), YD-011 (bisphenol A type unmodified solid epoxy resin), YD-012 (bisphenol A type solid epoxy resin), YD-014 (bisphenol A type unmodified solid epoxy resin), YDF-170 (bisphenol F type liquid type epoxy resin), YDF-2001 (100% bisphenol F type Taffy process solid epoxy resin), which are manufactured by KUKDO CHEMICAL CO. LTD., and so forth.

With a view to realizing a high thermal characteristics required to the MCCL adhesive surface, the epoxy resin may include at least one multi-functional epoxy resin containing at least two multi-functional epoxy groups, such as a phenol novolac type epoxy resin, a cresol novolac type epoxy resin, a bisphenol A novolac type epoxy resin, a polyvalent phenol type epoxy resin, a tetraphenol type epoxy resin, a phenol-dicyclopentadiene type epoxy resin, etc. Examples of the multi-functional epoxy resin commercially available may include YDPN-631 (phenol novolac type epoxy resin), YDPN-638 (phenol novolac type epoxy resin), YDCN-500-1P (cresol novolac type epoxy resin), YDCN-500-4P (cresol novolac type epoxy resin), YDCN-500-5P (cresol novolac type epoxy resin), YDCN-500-8P (cresol novolac type epoxy resin), YDCN-500-10P (cresol novolac type epoxy resin), YDCN-500-80P (cresol novolac type epoxy resin), YDCN-500-90P (cresol novolac type epoxy resin), KBPN-110 (bisphenol A(BPA)-novolac type epoxy resin), KBPN-115 (BPA-novolac type epoxy resin), KBPN-120 (BPA-novolac type epoxy resin), KDMN-1065, KDCP-130 (dicyclopentadiene (DCPD) type epoxy resin), which are manufactured by KUKDO CHEMICAL CO. LTD., and so forth.

In order to overcome the deterioration of the adhesion to the copper foil caused by the inorganic filler necessarily contained to enhance the heat radiation (thermal conductivity) of the MCCL adhesive, the composition may include at least one modified epoxy resin prepared by reacting a silicon compound represented by the following Chemical Formula 1 and an epoxy resin:

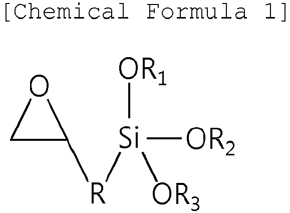

In the above chemical formula, R is an aliphatic or aromatic alkylene group; and R₁, R₂, and R₃ are independently an aliphatic or aromatic alkyl group. For example, R may be selected from the group, if not limited to, consisting of C₁-C₂₀ alkylene group, arylene group, arylalkylene group, and alkyl arylene group; and R₁, R₂, and R₃ may be independently selected from the group consisting of, if not limited to, C₁-C₂₀ alkyl group, aryl group, arylalkyl group, and alkylaryl group.

The modified epoxy resin having the silicon element modified may be obtained by reacting an alkoxy group of the silicon compound and an aliphatic hydroxyl group of the epoxy resin. By substituting the silicon compound to the hydroxyl group that serves to increase the adhesion between the epoxy resin and the interface, the density of the alkoxy group is increased to enhance the interfacial adhesion. Preferably, the modified epoxy resin may include the silicon compound so that the content of silicon (Si) is 0.3 to 3.0 wt% with respect to the total weight of the resin. When the silicon content is less than 0.3 wt%, it is difficult to enhance the adhesion to a desired level. When the silicon content is greater than 3.0 wt%, a complete reaction between the epoxy resin and the silicon compound is hard to achieve and the remaining silicon compound possibly causes deterioration in the thermal characteristics or the like. Further, the average epoxy equivalent weight of the modified epoxy resin is preferably in the range of 170 to 1,000 g/eq in consideration of the properties such as adhesion or the like. On the other hand, the metals other than silicon are unreactive or less reactive. Examples of the modified epoxy resin may include KSR-176, KSR-177, KSR-276, KSR-900, etc., which are manufactured by KUKDO CHEMICAL CO. LTD. The mixing ratio of the modified epoxy resin and other epoxy resins in terms of weight is preferably in the range of 0.5:9 to 9:0.5. An extremely low amount of the modified epoxy resin may result in brittle coating film or poor coatability, and an extremely high amount of the modified epoxy resin may lead to insufficient curing and poor coatability.

In addition, the epoxy resin composition may include at least one material having a high molecular weight and elasticity, such as modified epoxy resin derived from an elastic rubber or an elastic material having substituent, in order to improve the problem in regards to the brittleness of the cured material of the epoxy resin due to its high crosslink density. Preferred examples of the elastic material may include a nitro-butadiene rubber substituted with carboxyl groups, a butadiene liquid rubber substituted with carboxyl groups on both ends thereof, a butadiene liquid rubber substituted with amine groups on both ends thereof, an acryl core cell, and so forth. Examples of the liquid rubber containing substituent may include N631, N34, 1072S, DN601, Nipol 1071, which are all manufactured by NIPPON ZEON, and so forth. Examples of the epoxy resin containing an acryl core cell may include KR-628 (acryl rubber-modified epoxy resin), KR-629 (acryl rubber-modified epoxy resin), KR-693 (acryl rubber-modified epoxy resin), which are all manufactured by KUKDO CHEMICALS CO., LTD.), and so forth.

On the other hand, the control of the degree of crystallization in the cured material is a very important factor in the thermal conductivity (heat radiation) characteristics of the insulating layer. When heat is transferred in a certain medium, the transfer rate of the heat increases with a decrease in the transfer path. The fast heat transfer of a metal material is greatly affected by a lattice structure of the metal that is a crystalline structure. Likewise, it may be easily predicted that the thermal conductivity increases with an increase in the degree of crystallization of a polymer material. Therefore, the epoxy resin composition may include a crystalline epoxy resin in order to increase the degree of crystallization in the cured material. The types of the crystalline epoxy resin include a biphenyl type epoxy resin, a tetramethyl biphenyl type epoxy resin, a bisphenol S type epoxy resin, an ultra high purity bisphenol A type epoxy resin, an ultra high purity bisphenol F type epoxy resin, and so forth. Examples of the crystalline epoxy resins commercially available are YSLV-50TE, YSLV-80DE, YSLV-80XY, YSLV-90CR, YSLV-120TE, and YDC-1312, which are all manufactured by NIPPON STEEL CHEMICAL), or KDS-8128 (ultra high purity, low viscosity, low chlorine bisphenol A type epoxy resin), KDS-8170 (ultra high purity, low viscosity, low chlorine bisphenol F type epoxy resin), KDS-8128P, and KDS-8170P, which are all manufactured by KUKDO CHEMICALS CO. LTD., and so forth.

Another method for controlling the degree of crystallization in the cured material of the epoxy resin composition is maintaining the orientation of the chain of the polymer to be constant and thereby increasing the crystalline region in the chain of the polymer. Due to the orientations of the chains under defined conditions, the chain of the polymer may be crystalline in a certain region and amorphous in another region. For this reason, an epoxy resin having a high equivalent weight of 1,500 g/eq or greater and/or the phenoxy resin that is an epoxy resin having a high molecular weight of 20,000 g/mol or greater has a relatively long chain length with respect to other epoxy resins and thus may be expected to have the crystallization effect caused by the orientation among the chains. By partially applying the epoxy resin having a high equivalent weight and/or a phenoxy resin, the degree of crystallization of the adhesive composition can be increased by the orientation of the long chain of the resin. An epoxy resin having an equivalent weight less than 1,500 g/eq and a phenoxy resin having a weight average molecular weight less than 20,000 g/mol do not have a sufficiently long molecular chain, so it is not expectable to get a sufficient crystallization effect with the orientation among the chains. The upper limit of the equivalent weight of the epoxy resin having a high equivalent weight may be, for example, 7,000 g/eq, and the upper limit of the molecular weight of the phenoxy resin may be, for example, 70,000 g/mol. The epoxy resin having a high equivalent weight available is not specifically limited as long as it's equivalent weight is 1,500 g/eq or greater. Such an epoxy resin with a high equivalent weight is preferably an epoxy resin having a difunctional single chain, such as a bisphenol A type epoxy resin, a bisphenol F type epoxy resin, a bisphenol A/F type epoxy resin, a bisphenol S type epoxy resin, and so forth. Examples of the epoxy resin commercially available are YD-017 (bisphenol A type solid epoxy resin), YD-019 (bisphenol A type solid epoxy resin), YD-020 (high purity bisphenol A type solid epoxy resin), ZX-217, etc., which are all manufactured by KUKDO CHEMICAL CO., LTD. The phenoxy resins available may preferably include, but are not specifically limited to, a bisphenol A type phenoxy resin, a bisphenol F type phenoxy resin, a bisphenol A/F type phenoxy resin, a fluorene-based phenoxy resin, and so forth. Examples of the phenoxy resin commercially available are YP-50 (Unmodified bisphenol A type phenoxy resin), YP-70 (bisphenol A/bisphenol F type phenoxy resin), which are all manufactured by KUKDO CHEMICAL CO., LTD., FX-293, etc., which is manufactured by NIPPON STEEL CHEMICAL.

Another important factor is controlling the molecular weight of the epoxy resin due to the nature of the coating process of the present invention. A preferred epoxy resin composition is a resin composition having a weight average molecular weight in the range of 2,000 g/mol to 60,000 g/mol excluding inorganic filler. When the molecular weight of the epoxy resin composition is less than 2,000 g/mol, the interfacial energy of the metal plate surface to be coated becomes lower than the surface tension of the adhesive due to the high dry heat generated during the continuous roll-coating process, thereby causing the adhesive to agglomerate on the surface of the metal plate, ending up with a serious deterioration in the coatability, and the resin possibly flows out on the surface of the press due to the high pressure in the vacuum pressing process with the copper foil after the coating process, consequently with a high risk of contaminating the equipment. Contrarily, when the molecular weight of the epoxy resin composition is greater than 60,000 g/mol, such a high molecular weight leads to an extremely high viscosity of the adhesive composition solution to deteriorate the wetness and causes defects on the appearance of the surface and also deteriorates the solubility in the solvent in the aftertreatment process, thereby lowering the productivity.

On the other hand, the adhesive resin composition may further include an inorganic filler in order to provide a heat radiation characteristic in the adhesive layer. The inorganic filler may include metal oxides, silicon oxides, metal hydrates, and so forth. The inorganic filler is not specifically limited in its type and may preferably include an aluminum oxide (hereinafter, referred to as "alumina") excellent in thermal conductivity and commercially competitive. The alumina commercially available comes in different types depending on its preparation method, particle shape and particle size. The alumina used to form the adhesive composition of the present invention is not specifically limited in its type. Particularly, the preferred alumina has an average particle size of 3.0 µm or less. When the average particle size of the alumina is greater than 3.0 µm, the high-temperature dry conditions after the coating step in the continuous roll-coating process may cause a boiling on the surface. In this case, the frequency and magnitude of the boiling are in proportion to the average particle size. Further, the degree of dispersion after the milling process on the alumina is preferably 30 µm or less. The content of the alumina is preferably confined to 40 to 70 wt% with respect to the total solid weight of the adhesive composition. When the content of the alumina is less than 40 wt%, the thermal conductivity may be abruptly deteriorated. Contrarily, when the content of the alumina is greater than 70 wt%, the thermal conductivity is high but the viscosity of the solution is increased to cause agglomeration of the resin during the roll coating process, thus making it difficult to obtain a uniform coating.

In the adhesive composition, the curing agent is preferably a resin that is reactive with an epoxy group or a hydroxyl group at high temperature. The preferred curing agent is a resin or a compound that is very slow or inactive in the reaction with an epoxy resin at the room temperature and initiated to react with the epoxy resin at a defined temperature or above.

Generally, using a novolac-based resin as a curing agent of the epoxy resin is advantageous in that the novolac-based resin remains stable for a very long period of time after mixed with the epoxy resin due to its considerably low reactivity with the epoxy resin at the room temperature, the reaction rate becomes faster when heated to a defined temperature, for example, 100°C or above, the reaction rate is controllable by addition of a catalyst or the like, and the thermal characteristics such as lead thermal resistance after curing may be greatly enhanced. Examples of the novolac resin may include a phenol novolac resin, a cresol novolac resin, a bisphenol A type novolac resin, a phenol-dicyclopentadiene resin, a cresol-dicyclopentadiene resin, and so forth. More preferably, the novolac-based resin may be a phenol novolac resin having a softening temperature in the range of 80 to 130°C. When the softening temperature of the phenol novolac resin is lower than 80°C, the crosslink density is seriously too low to secure a desired lead thermal resistance. Contrarily, when the softening temperature of the phenol novolac resin is higher than 130°C, the crosslink density may be high, but with difficulty in acquiring properties remarkably more excellent than the desired lead thermal resistance, and the adhesion is seriously poor.

The acid anhydride compounds can also be a useful curing agent, because they have a considerably low reactivity with the epoxy resin at the room temperature and show a faster reaction rate at a defined temperature or above. Particularly, the acid anhydride-based curing agent is advantageously excellent in electrical characteristics and thus widely used as a curing agent for transformer molds. The more preferred acid anhydride is an acid anhydride containing a nadic group as represented by the following chemical formula. As the acid anhydride contains a nadic group in the structure, it inhibits the electron transfer in the cured chain after the curing process to enhance the electrical characteristics and alleviates the hydrogen bonding with water to make the water absorption more stable.

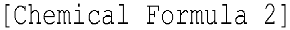

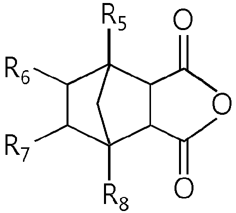

In the above chemical formula, R₅, R₆, R₇, and R₈ are independently hydrogen (H) or an aliphatic or aromatic alkyl group. For example, R₅, R₆, R₇, and R₈ are independently selected from the group consisting of, it not limited to, hydrogen, a C₁-C₂₀ alkyl group, an aryl group, an arylalkyl group, and an alkylaryl group.

Further, the aromatic amine-based compounds are also useful, because they have a considerably low reactivity with the epoxy resin at the room temperature and showy a reaction rate increased at a defined temperature or above. Particularly, the aromatic amine is characterized in that the resultant cured material after the curing reaction with the epoxy resin is excellent in adhesion and thermal resistance. The preferred aromatic amine is an aromatic amine containing a sulfonyl group in the structure as represented by the following chemical formula. The aromatic amine containing a sulfonyl group is useful because it is more excellent in the thermal characteristics of the resultant cured material than the amines not containing a sulfonyl group, hardly subjected to liquefaction caused by the isomers and less toxic to the human body.

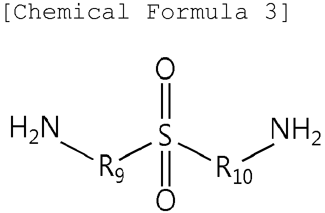

In the above chemical formula, R₉ and R₁₀ are independently an aromatic alkylene group. For example, R₉ and R₁₀ are independently selected from the group consisting of, if not limited to, a C₁-C₂₀ arylene group, an arylalkylene group, and an alkylarylene group.

Further, the adhesive composition may include a curing agent that is considerably fast in reacting with the hydroxyl group contained in the molecular chain of the epoxy resin or the phenoxy resin at a defined temperature or above. The representative examples of the preferred curing agent are a urea resin, a melamine resin, a phenol resol derivative, and so forth.

The adhesive composition may further include a curing accelerator according to the speed of the continuous roll-coating line and the conditions of the dry oven. The preferred examples of the curing accelerator may include imidazole compounds, such as methyl imidazole, phenyl imidazole, 2-ethyl-4-methyl imidazole, etc.; basic catalysts such as organic-phosphorous complexes (e.g., triphenyl phosphine, ethyltriphenyl phosphine iodide, ethyltriphenyl phosphine bromide, etc.); or acid catalysts, such as boron trifluoride complex, phosphate compound, etc.

The dispersing agent of the adhesive composition is adsorbed onto the inorganic filler to cause electrostatic repulsion or steric hindrance and thus maintain the gap between the pigments to be constant, thereby preventing re-agglomeration of the composition dispersed and prepared and enhancing the fluidity of the composition. The dispersing agent is properly selected so long as it does not deteriorate the fluidity of the composition. Examples of the dispersing agent may include the products of BYK, such as DISPERBYK-110 series, DISPERBYK-160 series, DISPERBYK-170, or DISPERBYK-171; and the products of EFKA, such as EFKA-4009, 4015, 4020, 4300, 4330, 4400, 4401, 4500, 4550, etc. A preferred dispersing agent is a block copolymer dispersing agent having a high molecular weight and containing a functional group with affinity to the pigments, which block copolymer dispersing agent may be used in a proper amount.

In addition, the insulating adhesive composition according to the present invention may include additives, such as a coupling agent, a leveling agent, an anti-foaming agent, and so forth. The coupling agent may be a silane coupling agent such as Z-6040 (manufactured by DOW CORNING); the leveling agent may be Polyflow No. 90D-50 (manufactured by HANSUNG INDUSTRY CO., LTD.), etc.; and the anti-foaming agent may be an acryl-based anti-foaming agent, etc.

The solvent for the adhesive composition preferably includes at least one solvent having a boiling temperature of 70 to 149°C and at least one solvent having a boiling temperature of 150 to 230°C. More specifically, the preferred solvent is a ketone-based solvent such as methylethyl ketone (MEK, boiling temperature: about 80°C) to which the epoxy resin has a high solubility. As the ketone-based solvent has a low boiling temperature, it needs to be used in combination with dibasic ester (DBE, boiling temperature: 196 to 225°C), propylene glycol methyl ether (PGME), or aromatic hydrocarbon-based solvents. This can effectively prevent the coating film from boiling in the drying step of the roll-coating process. The mixing ratio of the solvent having a low boiling temperature and the solvent having a high boiling temperature in terms of weight is preferably in the range of 1:9 to 9:1.

Table 1 illustrates the ingredients and the contents of the insulating adhesive composition according to one embodiment of the present invention, which is not intended to limit the scope of the present invention and may be properly modified.

**[Table 1]**

| Div. | Ingredient | Content (wt%) |
|---|---|---|
| Main resin | Epoxy resin (one or more) | 10 - 50 |
| Curing agent | Phenol novolac resin, etc. | 1 - 30 |
| Curing accelerator | Imidazole | 0.01 - 2 |
| Dispersing agent | Acryl-based | 0.01 - 2 |
| Coupling agent | Silane-based | 0.01 - 2 |
| Leveling agent | Acryl-based | 0.01 - 2 |
| Inorganic filler | Alumina | 10 - 50 |
| Solvent | Methylethylketone (MEK) | 5 - 50 |
| | DBE | 5 - 50 |
| | PGME | 5 - 50 |
| | Aromatic hydrocarbon-based | 0 - 10 |

Referring to Table 1, the main resin may be at least one epoxy resin. More specifically, the main resin may include, indispensably, a silane-modified epoxy resin using the compound of the Chemical Formula 1 as a principal resin and an epoxy resin having a high equivalent weight or a high molecular weight as an auxiliary resin, and optionally at least one resin selected from a di-functional epoxy resin, a multi-functional epoxy resin, a crystalline epoxy resin, and a rubber-modified epoxy resin. The weight ratio of the silane-modified epoxy resin and the epoxy resin having a high equivalent weight or a high molecular weight may be in the range of 1:9 to 9:1. The total content of the main resin may be in the range of 10 to 50 wt%, preferably 20 to 40 wt%, with respect to the total weight of the adhesive composition.

The curing agent may include indispensably at least one selected from a phenol novolac resin, an acid anhydride of the Chemical Formula 2, and an aromatic amine of the Chemical Formula 3 and optionally an urea resin, a melamine resin, a phenol resol derivative, and so forth. The content of the curing agent may be in the range of 1 to 30 wt%, preferably 1 to 20 wt%, with respect to the total weight of the adhesive composition.

The curing accelerator may be imidazole or the like. The content of the curing accelerator may be in the range of 0.01 to 2 wt%, preferably 0.01 to 1 wt%, with respect to the total weight of the adhesive composition.

The dispersing agent may be an acryl-based dispersing agent or the like. The content of the dispersing agent may be in the range of 0.01 to 2 wt%, preferably 0.1 to 1 wt%, with respect to the total weight of the adhesive composition.

The coupling agent may be a silane-based coupling agent or the like. The content of the coupling agent may be in the range of 0.01 to 2 wt%, preferably 0.1 to 1 wt%, with respect to the total weight of the adhesive composition.

The leveling agent may be an acryl-based leveling agent or the like. The content of the leveling agent may be in the range of 0.01 to 2 wt%, preferably 0.1 to 1 wt%, with respect to the total weight of the adhesive composition.

The inorganic filler may be alumina or the like. The content of the inorganic filler may be in the range of 10 to 50 wt%, preferably 25 to 45 wt%, with respect to the total weight of the adhesive composition.

The solvent may include at least two solvents having a low boiling temperature (70 to 149°C) and a high boiling temperature (150 to 230°C). More specifically, the solvent may include MEK, DBE, PGME, aromatic hydrocarbon-based solvents, and so forth. As for the content of the solvent, the content of MEK, DBE, or PGME may be in the range of 5 to 50 wt%, preferably 5 to 30 wt%, with respect to the total weight of the adhesive composition; and the content of the aromatic hydrocarbon-based solvent may be in the range of 0 to 10 wt% with respect to the total weight of the adhesive composition. The total content of the solvent may be in the range of 10 to 80 wt%, preferably 25 to 65 wt%, with respect to the total weight of the adhesive composition.

Hereinafter, a detailed description will be given as to a method for manufacturing an adhesive-coated metal plate using the insulating adhesive composition and the roll-coating line.

FIG. 1 is a cross-sectional diagram showing the structure of an adhesive-coated metal plate for metal printed circuit board prepared according to one embodiment of the present invention. The adhesive-coated metal plate may include, in the order from bottom to top, a metal plate 10, a first insulating adhesive layer 20, a second insulating adhesive layer 30, and a copper foil layer 40.

In order to prepare an insulating adhesive-coated metal plate for metal printed circuit board in the continuous roll-coating line, a coil metal plate, such as an aluminum plate, a magnesium plate, a melt aluminum-coated steel plate, a melt aluminum-zinc alloy-coated steel plate, a melt zinc-coated steel plate, an electrical zinc-coated steel plate, or the like, is continuously fed at a production rate of 20 to 100 mpm (m/min). The thickness of the metal plate may be 0.3 mm or greater.

An alkali solution is sprayed onto the surface of the metal plate continuously fed, to wash away foreign substances such as rust-preventing oil or dusts. Also, the surface of the metal plate to be coated with the insulating adhesive is rubbed with a brush. The brushing process is carried out to enhance the adhesion between the metal plate and the insulating adhesive by increasing the surface area of the metal plate and to eliminate aluminum chips sticking to the cut surface in the case where the metal plate is an aluminum steel plate.

It may be possible to install a magnetic filter in the adhesive solution prior to the roll-coating process and thus eliminate the iron oxide components. The reason of using the magnetic filter lies in that the iron oxide contained in the filler as an impurity possibly deteriorates the withstand voltage characteristics of the insulating adhesive to adversely affect the quality of the final product.

The insulating adhesive solution is repeatedly applied onto the surface of the cleaned metal plate at least once, preferably at least twice. When the thickness of the coating film is greater than 50 µm after one time of the coating process, the coating film may be boiled during the drying process. It is possible to prevent the coating film from boiling by repeatedly carrying out the coating process. The roll-coating process is performed so that the dry coating film thickness of the insulating adhesive solution is 10 to 50 µm after one time of the coating process. Subsequent to the roll-coating process, the metal plate is heated up to 170 to 250°C in a dry oven and dried out. The drying time is several seconds to one minute or less. The repetitive coating process is carried out to make the final thickness of the insulating adhesive in the range of 40 to 120 µm. When the coating film thickness is less than 40 µm, the withstand voltage properties deteriorate. Contrarily, when the coating film thickness is greater than 120 µm, the thermal conductivity is greatly decreased. A protective film may be continuously applied onto the dry insulating adhesive coating film. The protective film is used to prevent a possible damage on the surface of the insulating adhesive coating film in the subsequent process and protect the surface of the insulating adhesive coating film against moisture.

The method for manufacturing a metal printed circuit board may include the steps of cutting an adhesive-coated metal plate into a predetermined size, laminating five to twenty sets of the adhesive-coated metal plate and a copper foil in sequential order, and then pressing in a vacuum press of 10 torr or below at the temperature of 150 to 250°C and under the pressure of 10 to 50 kgf/cm² for 0.5 to 2.5 hours, and finally performing a cold pressing for 0.1 to 1 hour.

As a result of applying the adhesive resin composition according to the present invention in the continuous roll-coating line, it is possible to acquire desired properties in the present invention, that is, the properties required to the metal printed circuit board, such as adhesion, withstand voltage properties, thermal resistance, moisture resistance, or the like. Further, the production method using the continuous roll-coating process can enhance the productivity relative to the conventional production method.

Hereinafter, the present invention will be described in further detail with reference to the following examples, which include preparing an adhesive-coated metal plate using the adhesive composition of the present invention in the continuous roll-coating line and adhering a copper foil to the adhesive-coated metal plate in the vacuum pressing process to complete a metal printed circuit board. Further, the effects of the present invention are made apparent by way of the experimental examples that evaluate the quality of the completed metal printed circuit board. However, the examples are not intended to limit the scope of the present invention.

### [Example 1]

### 1. Preparation of main resin solution

20 g of KSR-177 (di-functional silane-modified epoxy resin, manufactured by KUKDO CHEMICAL CO., LTD., epoxy equivalent weight 201 g/eq, viscosity 13,100 cps @ 25°C), 10 g of YD-128 (di-functional bisphenol A type epoxy resin, manufactured by KUKDO CHEMICAL CO., LTD., equivalent weight 186 g/eq, viscosity 12,800 cps @ 25°C), 10 g of YDPN-638 (phenol novolac epoxy resin, manufactured by KUKDO CHEMICAL CO., LTD.) and 60 g of YP-50 (bisphenol A type phenoxy resin, manufactured by NIPPON STEEL CHEMICAL, weight average molecular weight 65,000 g/mol) were completely dissolved in 60 g of methylethylketone and 60 g of propylene glycol methyl ether to prepare a main resin solution. In this regard, the average molecular weight of the main resin solution was 39,000 g/eq.

### 2. Preparation of master batch

The total amount of the main resin solution, 150 g of AL-160SG-3 (thermally activated ultra fine alumina, manufactured by SHOWA DENKO, average particle diameter 0.55 µm), 2 g of DisperBYK-110 (manufactured by BYK, dispersing agent), 2 g of Z-6040 (manufactured by DOW CORNING, silane-based coupling agent), 2 g of Polyflow No. 90D-50 (manufactured by HANSUNG INDUSTRY CO., LTD., leveling agent) and 30 g of DBE as a diluent solvent were mixed together using a basket mill through the ball milling process to prepare a master batch, while the average particle size of the alumina particles was controlled to 30 µm or less by way of a particle size analyzer.

### 3. Preparation of curing agent

5 g of KPN-116 (phenol novolac resin, manufactured by KANGNAM HWASUNG CO., LTD., softening temperature 110°C), 6 g of MNA (methyl nadic anhydride, manufactured by HITACHI CHEMICAL CO., LTD., corresponding to Chemical Formula 2), and 0.2 g of 2-phenyl imidazole (2PI, HITACHI CHEMICAL CO., LTD.) were completely dissolved in 4 g of propylene glycol mono-methyl ether to prepare a curing agent.

### 4. Preparation of adhesive

The total amount of the master batch and the total amount of the curing agent were mixed together to prepare an insulating adhesive composition suitable for the continuous roll-coating line.

### 5. Preparation of adhesive-coated metal plate

An adhesive-coated metal plate was prepared according to the conditions of the continuous roll-coating process as follows.
- Metal plate material: Aluminum 5052, thickness 1.0 mm, width 1,000 mm
- Line progress speed: 25 mpm
- Peak metal temperature (PMT): 216°C
- Dry coating film thickness of insulating adhesive: total 80 µm (two times of coating, each 40 µm)

The other working conditions were the general conditions of the continuous roll-coating process.

### 6. Preparation of MCCL

A high-temperature, high-pressure lamination process with a copper foil was carried out to prepare a MCCL. More specifically, an electrolytic copper foil (1 oz) and an aluminum plate coated with the prepared insulating adhesive were subjected to a pressing process with a vacuum press at 205°C for 1.5 hour and then a cold pressing process for 30 minutes to prepare a metal copper clad laminate (MCCL) for metal printed circuit board (PCB).

### [Example 2]

10 g of KSR-276 (di-functional silane-modified solid epoxy resin, manufactured by KUKDO CHEMICAL CO., LTD., epoxy equivalent weight 430 g/eq, softening temperature 63°C), 10 g of YD-011 (di-functional bisphenol A type epoxy resin, manufactured by KUKDO CHEMICAL CO., LTD., equivalent weight 450 g/eq, softening temperature 65°C), 20 g of YDPN-638, and 60 g of YP-50 were completely dissolved in 60 g of methylethylketone and 60 g of propylene glycol mono-methyl ether to prepare a main resin solution. In this regard, the average molecular weight of the main resin solution was 41,000 g/eq. The other procedures were performed in the same manner as described in Example 1 to prepare and evaluate an MCCL.

### [Example 3]

10 g of KSR-177, 40 g of YSLV-50TE (thio bisphenol crystalline epoxy resin, manufactured by NIPPON STEEL CHEMICAL, epoxy equivalent weight 175 g/eq, melting temperature 46°C), and 60 g of YP-70 (bisphenol A/F type phenoxy resin, manufactured by NIPPON STEEL CHEMICAL, weight average molecular weight 55,000 g/mol) were completely dissolved in 60 g of methylethylketone and 60 g of propylene glycol mono-methyl ether to prepare a main resin solution. In this regard, the average molecular weight of the main resin solution was 31,500 g/eq. The other procedures were performed in the same manner as described in Example 1 to prepare and evaluate an MCCL.

### [Example 4]

10 g of KSR-177, 30 g of YSLV-50TE, 10 g of YSLV-80XY (methyl-substituted bisphenol F type crystalline epoxy resin, manufactured by NIPPON STEEL CHEMICAL, epoxy equivalent weight 190 g/eq, melting temperature 79°C), and 60 g of YP-70 were completely dissolved in 60 g of methylethylketone and 60 g of propylene glycol mono-methyl ether to prepare a main resin solution. In this regard, the average molecular weight of the main resin solution was 31,500 g/eq. The other procedures were performed in the same manner as described in Example 1 to prepare and evaluate an MCCL.

### [Example 5]

### 1. Preparation of main resin solution

30 g of KSR-177, 20 g of YD-128, 10 g of YDPN-638, 10 g of YP-50, and 30 g of Nipol 1071 (carboxyl-substituted butadiene rubber, manufactured by NIPPON ZEON) were completely dissolved in 80 g of methylethylketone and 40 g of propylene glycol mono-methyl ether to prepare a main resin solution. In this regard, the average molecular weight of the main resin solution other than the rubber content was 11,500 g/eq.

### 2. Preparation of master batch

The total amount of the main resin solution, 180 g of AL-160SG-3, 2 g of DisperBYK-110, 2 g of Z-6040, 2 g of Polyflow No. 90D-50, and 30 g of DBE as a diluent solvent were mixed together with a basket mill through the ball milling process to prepare a master batch, while the average particle size of the alumina particles was controlled to 30 µm or less by way of a particle size analyzer.

### 3. Preparation of curing agent

12 g of DDS (4,4-diaminodiphenylsulfone, aromatic divalent amine monomer, corresponding to the Chemical Formula 3) was completely dissolved in methylethylketone to prepare a curing agent.

The subsequent procedures were performed in the same manner as described in Example 1.

### [Comparative Example 1]

80 g of YD-128 and 40 g of YD-014 (bisphenol A type solid epoxy resin, manufactured by KUKDO CHEMICAL CO., LTD., epoxy equivalent weight 950 g/eq) were completely dissolved in 120 g of methylethylketone to prepare a main resin solution. In this regard, the average molecular weight of the main resin solution was 1,890 g/eq. The subsequent procedures were performed in the same manner as described in Example 1.

### [Comparative Example 2]

The procedures were performed in the same manner as described in Example 1, excepting that 10 g of DICY (cyanoguanidine) as a curing agent component was completely dissolved in PGME to prepare a curing agent. The subsequent procedures were performed in the same manner as described in Example 1.

### [Experimental Example]

The results of the quality tests for the MCCLs of Examples and Comparative Examples are presented in Table 2.

**[Table 2]**

| | Example | | | | | Comparative Example | |
|---|---|---|---|---|---|---|---|
| | 1 | 2 | 3 | 4 | 5 | 1 | 2 |
| Withstand voltage (kV) | 7.0 | 6.9 | 6.5 | 7.0 | 6.9 | 1.2 | 6.8 |
| Withstand voltage in boiling water (kV) | 5.5 | 5.7 | 6.0 | 5.8 | 5.1 | 0.2 | 3.2 |
| Adhesion to copper foil (kgf/cm) | 1.85 | 1.73 | 1.83 | 1.67 | 1.90 | 0.90 | 1.89 |
| Adhesion to copper foil in boiling water (kgf/cm) | 1.82 | 1.72 | 1.80 | 1.66 | 1.67 | 0.52 | 1.75 |
| Resistance to soldering (min) | ≥ 80 | ≥ 80 | ≥ 80 | 72 | 55 | < 1 | 2 |
| Coatability | Good | Good | Good | Good | Good | Bad | Good |
| Insulating layer thermal conductivity (W/mK) | 1.9827 | 1.9626 | 2.3532 | 2.4351 | 1.8135 | 1.6102 | 1.9257 |

In the test method for the withstand voltage, a withstand voltage tester was used to measure the maximum AC voltage that the insulating adhesive layer between the copper foil layer and the aluminum layer can tolerate.

In the test method for the withstand voltage in boiling water, a specimen was immersed in a boiling water for 2 hours, dried out for 30 minutes and then measured using a withstand voltage tester in regards to the maximum AC voltage that the insulating adhesive layer between the copper foil layer and the aluminum layer can tolerate.

In the test method for the adhesion to the copper foil, a 90-degree peel-off tester was used to measure the force required to forcibly peel off a copper foil having a width of 1 cm at 90°.

In the test method for the adhesion to the copper foil in boiling water, a specimen was immersed in a boiling water for 2 hours, dried out for 30 minutes and then measured using a 90-degree peel-off tester in regards to the force required to forcibly peel off a copper foil having a width of 1 cm at 90°.

In the test method for the resistance to soldering, a specimen was floated on a lead-free solder melting solution at 288°C and then measured in regards to the time required to form bubbles on the copper foil.

In the case of the coatability test, an adhesive was applied onto a metal plate and dried out, and the surface of the metal plate was observed to evaluate the quality of the surface as "good" for the smooth surface and "bad" for the surface with agglomerate of the adhesive or unevenness.

In the test method for the thermal conductivity of the insulating layer, only the adhesive layer was cured in the form of a film to prepare a specimen, which was then measured in regards to the thermal conductivity in the thickness direction using the laser flash method.

As can be seen from the results of Table 2, the Examples were excellent in all the properties. The Comparative Example 1 that used neither a silane-modified epoxy resin nor an epoxy resin having a high equivalent weight showed a considerable deterioration in all the properties, relative to the Examples. The Comparative Example 2 that used an aliphatic amine-based curing agent showed deterioration in the withstand voltage in boiling water and particularly considerable deterioration in the resistance to soldering.

It is apparent to those skilled in the art that the scope of the present invention is defined by the claims other than the detailed description of the invention and construed to include all the variations and modifications derived from the meanings and scope of the claims and their equivalents.

## Claims

1. An insulating adhesive composition for metal printed circuit board, comprising a modified epoxy resin prepared by reacting a silicon compound represented by the following Chemical Formula 1 and an epoxy resin: 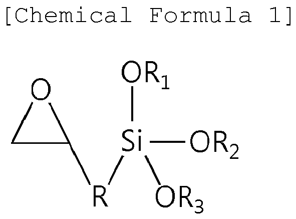 wherein R is an aliphatic or aromatic alkylene group; and R₁, R₂, and R₃ are independently an aliphatic or aromatic alkyl group.

2. The insulating adhesive composition for metal printed circuit board as claimed in claim 1, wherein the modified epoxy resin comprises 0.3 to 3 wt% of silicon (Si).

3. The insulating adhesive composition for metal printed circuit board as claimed in claim 1, wherein the modified epoxy resin has an average epoxy equivalent weight of 170 to 1,000 g/eq.

4. The insulating adhesive composition for metal printed circuit board as claimed in claim 1, wherein the insulating adhesive composition comprises an epoxy resin having a high equivalent weight, an inorganic filler, a curing agent, and an organic solvent.

5. The insulating adhesive composition for metal printed circuit board as claimed in claim 4, wherein the epoxy resin having a high equivalent weight is at least one selected from the group consisting of a solid epoxy resin having an equivalent weight of 1,500 to 7,000 g/eq and a phenoxy resin having a weight average molecular weight of 20,000 to 70,000 g/mol.

6. The insulating adhesive composition for metal printed circuit board as claimed in claim 4, wherein the insulating adhesive composition other than the inorganic filler has a weight average molecular weight of 2,000 to 60,000 g/mol.

7. The insulating adhesive composition for metal printed circuit board as claimed in claim 4, wherein the inorganic filler is aluminum oxide.

8. The insulating adhesive composition for metal printed circuit board as claimed in claim 4, wherein the inorganic filler has a particle size of 0.1 to 3.0 µm.

9. The insulating adhesive composition for metal printed circuit board as claimed in claim 4, wherein the inorganic filler is included in an amount of 40 to 70 wt% with respect to the total solid weight of the insulating adhesive composition.

10. The insulating adhesive composition for metal printed circuit board as claimed in claim 4, wherein the curing agent is any one or a mixture of at least two selected from the group consisting of a phenol novolac resin, an acid anhydride, an aromatic amine, an urea resin, a melamine resin, and a phenol resol derivative.

11. The insulating adhesive composition for metal printed circuit board as claimed in claim 10, wherein the phenol novolac resin has a softening temperature of 80 to 130°C.

12. The insulating adhesive composition for metal printed circuit board as claimed in claim 10, wherein the acid anhydride is an acid anhydride represented by the following Chemical Formula 2: 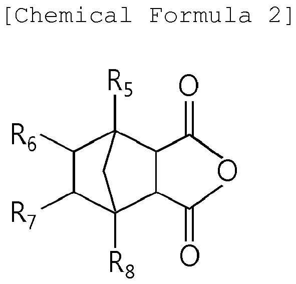 wherein R₅, R₆, R₇, and R₈ are independently hydrogen (H) or an aliphatic or aromatic alkyl group.

13. The insulating adhesive composition for metal printed circuit board as claimed in claim 10, wherein the aromatic amine is an aromatic amine represented by the following Chemical Formula 3: 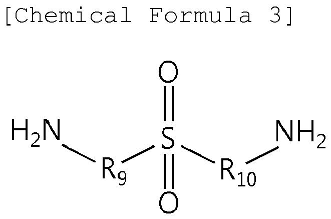 wherein R₉ and R₁₀ are independently an aromatic alkylene group.

14. The insulating adhesive composition for metal printed circuit board as claimed in claim 4, wherein the organic solvent comprises at least one solvent having a boiling temperature of 70 to 149°C and at least one solvent having a boiling temperature of 150 to 230°C.

15. An adhesive-coated metal plate for metal printed circuit board, comprising:
a metal plate; and
an insulating adhesive layer provided on the top of the metal plate and formed using an insulating adhesive composition containing a modified epoxy resin prepared by reacting a silicon compound represented by the following Chemical Formula 1 and an epoxy resin: 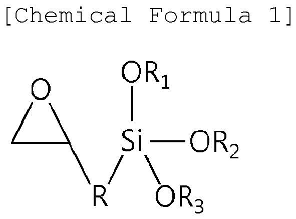
wherein R is an aliphatic or aromatic alkylene group; and R₁, R₂, and R₃ are independently an aliphatic or aromatic alkyl group.

16. The adhesive-coated metal plate for metal printed circuit board as claimed in claim 15, wherein the metal plate is selected from the group consisting of an aluminum plate, a magnesium plate, a melt aluminum-coated steel plate, a melt aluminum-zinc alloy-coated steel plate, a melt zinc-coated steel plate, and an electrical zinc-coated steel plate.

17. The adhesive-coated metal plate for metal printed circuit board as claimed in claim 15, wherein the insulating adhesive layer has a final coating film thickness of 40 to 120 µm.

18. A method for manufacturing an adhesive-coated metal plate for metal printed circuit board, comprising:
(a) continuously feeding a metal plate in a continuous roll-coating line; and
(b) coating the top of the metal plate with an insulating adhesive composition containing a modified epoxy resin prepared by reacting a silicon compound represented by the following Chemical Formula 1 and an epoxy resin and then drying the coated metal plate to form an insulating adhesive layer: 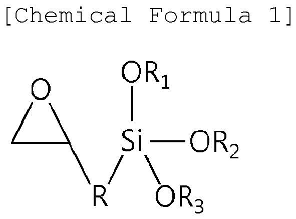 wherein R is an aliphatic or aromatic alkylene group; and R₁, R₂, and R₃ are independently an aliphatic or aromatic alkyl group.

19. The method as claimed in claim 18, wherein the step (b) includes repeatedly performing the coating process using the insulating adhesive composition and drying process at least twice.

20. The method as claimed in claim 18, further comprising:
adjusting the surface of the metal plate with a brush after the step (a).

21. The method as claimed in claim 18, further comprising:
applying a protective film after the step (b).

22. The method as claimed in claim 18, further comprising:
installing a magnetic filter in the insulating adhesive composition to eliminate an iron oxide component before the step (b).
